# EUROPEAN PATENT APPLICATION

(11) **EP 0 613 056 A1**
(43) Date of publication of application: **31.08.1994**
(21) Application number: 94301226.0
(22) Date of filing: 22.02.1994
(51) Int. Cl.: G03G 7/00, G03F 1/00, G03F 7/12

(54) **Screen printing origination film**

(30) Priority: 26.02.1993 GB 9303950
(71) Applicant: AUTOTYPE INTERNATIONAL LIMITED, Wantage Oxfordshire OX12 7BZ (GB)
(72) Inventor: Sheldon, Mark Hedley, Schaumburg, Illinois 60173 (US); Warne, Stephen James, Wantage, Oxfordshire OX12 7EA (GB); Woolrich, Brian, Wantage, Oxfordshire OX12 0NG (GB)
(74) Representative: W.P. THOMPSON & CO.

(57) **Abstract**

The film comprises a base layer 1 of filled polyester, coated with a toner-receptive layer 2 of filled polyvinyl alcohol having a surface roughness of 3 to 15µm, and with a photosensitive emulsion layer 3. The film can be imaged in a laser printer, applied to a printing screen, the screen exposed, the film removed to leave the photosensitive layer, and the photosensitive layer developed to produce a printing screen.

## Description

This invention relates to origination films for use in screen printing.

In a widely used method of preparation of screen printing stencils an emulsion which is sensitive to actinic light is brought in contact with a woven screen and dried to form a photoresist. A origination film consisting of a film carrier carrying a positive image is placed in contact with the dry photoresist and the whole is exposed to high intensity actinic light, generally provided by a mercury-metal halide source, or a UV-fluorescent tube.

The areas of photoresist struck by the light cross-link and harden: the areas protected by the image area of the positive remain unhardened. On subsequent development, usually by water washing, the unhardened areas, which remain soluble, are removed, leaving a stencil having a negative image in the open areas of the screen. During the subsequent printing operation, ink is forced through the open areas of the stencil onto a suitable stock, thereby reproducing the original positive image. Generally, the positive image is made using high contrast silver films: in the case of colour printing, colour separations have to be produced, necessitating one silver photographic film for each colour to be printed. The cost of the silver films used in the process can be very considerable.

Recently there has been considerable interest in the use of digitised information in printing processes. Such information can be created and manipulated on a computer, without the production of hard copy, until all changes have been satisfactorily completed.

Clearly, it is desirable to be able to produce a screen printing origination film by an electrophotographic process, for example in a laser printer or photocopier, where such production can be under direct computer control and can avoid or minimise the preparation of any intermediate hard copy.

Laser printers and photocopiers have however certain characteristics which would lead to disadvantages in the direct production of a screen printing origination film. Two such characteristics are:
(a) The image produced by laser printers tends not to to be totally continuous and contains defects, among which are pinholes. If not corrected, this will create spots of hardened stencil material during exposure, which will lead to 'speckling' of the final print.
(b) The image produced by a laser printer is susceptible to central void formation - the reduction of image density at the centre of solid 'blocks' of the black image.

The present invention provides an origination film for use in screen printing, the film comprising a translucent base film having a toner-receptive surface for receiving toner in an electrophotographic process.

The toner-receptive surface may be a surface of the base film but is preferably a surface of an additional layer extending over the base film.

The surface roughness of the toner-receptive surface is preferably in the range 3 to 15 µm, more preferably 5 to 12 µm.

The additional layer preferably comprises a binder containing a high proportion of an inert filler.

The ratio of binder to filler in the additional layer is preferably in the range from 1:1 to 5:1, by weight.

Conveniently, the base film is rendered translucent by the inclusion of a filler material, suitable fillers being, for example, silica and china clay.

The base film may be a suitable proprietary filled film.

The invention can thus provide an origination film suitable for use in laser printers or copying machines onto which the final image is produced: the imaged film is then suitable for use as a photographic positive in screen stencil manufacture.

The base film is preferably of polyester.

The base film preferably has a transmission density to UV light in the range of from 0.1 to 0.4 preferably over the wavelength range of 320 to 400 nm. This may be measured using a Macbeth densitometer using a UV filter.

The binder of the additional layer may be polyvinyl alcohol but other materials can be used instead, for example polyamides and polyesters.

Examples of suitable fillers for inclusion in the additional layer are silica, china clay and synthetic resin fillers, for example cross-linked urea-formaldehyde resins.

The base film is preferably from 50 to 100 µm, more preferably from 70 to 80 µm and most preferably about 75 µm, in thickness.

Any additional layer is preferably from 5 to 20 µm, more preferably about 10 µm, in thickness.

Advantageously, the side of the base film opposite to the toner-receptive surface is coated with a photosensitive emulsion which can be exposed imagewise to actinic light to form a screen printing stencil.

The emulsion coating is preferably from 10 to 50 µm, more preferably 20 to 40 µm and most preferably about 30 µm, in thickness.

Such a film can be imaged electrophotographically, for example, by passing it through a laser printer or photocopier and the emulsion then placed in contact with a screen printing screen and adhered thereto by a suitable penetrating agent such as water or a water-alcohol mixture, which can be supplied by pre-wetting the screen. After drying, the emulsion firmly adheres to the mesh. The screen may then be imagewise exposed to actinic light through the positive image, the film removed and the stencil developed, usually by washing with water. Used in the mode just described, the film is processed as a "direct-indirect" or a "capillary" film. In another mode, the stencil may be made by the "indirect" method. In this, a suitable "indirect" emulsion is coated on the reverse side of the film. After producing the positive image electrophotographically, for example, by a laser printer or photocopier, the film is exposed to actinic light through the positive image, washed out and the wet developed stencil transferred to a suitable mesh.

The emulsion-coated films of the invention have the advantage that the intimate contact between the origination film and the emulsion layer during exposures renders the use of a point source of actinic light unnecessary and allows a diffuse light to be used instead.

In use of a film according to any aspect of the invention, the light to which the photosensitive emulsion is exposed passes, after accessing the image, through the base layer which causes scattering of the pinpoints of light caused by defects in the integrity of the image and reduces the intensity of this light incident on the photoresist to the point where it is insufficient to cause photohardening.

The base film of the present invention should therefore have sufficient transparency to transmit the actinic light for exposure of a photosensitive screenprinting emulsion and scattering properties sufficient to have the effect mentioned in the preceding paragraph. The term "translucent" when applied to the base film is used accordingly.

The use in a film according to a preferred aspect of the invention of a highly filled surface coating layer creates a greatly increased surface area at the surface, and improves take-up of the toner image. This significantly increases the density of the image, to prevent 'burn through' and reduce central void formation.

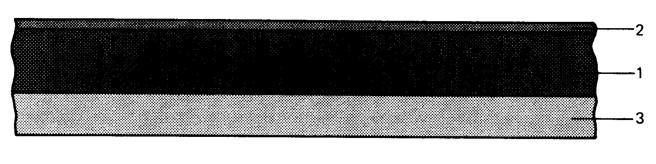

The invention will now be described by way of example with reference to the drawing and the following examples.

The single figure of the drawing shows, schematically, a film comprising a base layer 1 of filled polyester, coated on one face with a toner-receptive layer 2 and on the other face with a photosensitive emulsion layer 3.

### EXAMPLE 1

Preparation of a toner receptive emulsion coating. The following premixes were prepared.
Premix A - A 20% w/w solution of polyvinyl alcohol was prepared by mixing 20g of GOHSENOL GH20 polyvinyl alcohol into 80g of hot water using a high shear blender.
Premix B - 0.2g of FLUORAD FC 135 surfactant was dispensed in 100g of cold water. The resulting solution was used to wet out 15g of PERGOPAK M4 cross-linked urea-formaldehyde resin powder, forming a slurry. Premix A was cooled and Premix B added to it. The premixes were mixed using a high shear blender.

### EXAMPLE 2

Preparation of a toner receptive film for use as a positive in the production of a screen printing stencil.
The emulsion prepared according to example 1 was applied to MELINEX 377 polyester base (75µm gauge) by use of a 20 thou wire-wound bar. After drying, the coated film was printed with a block image from a 600 dpi laser printer. The film positive produced was placed in front of a 25µm capillary film stencil (AUTOTYPE CAPILLEX 25) on a 90TU polyester mesh which was exposed to a 5kW metal halide lamp at a distance of 1.2m for three minutes. Upon development of the stencil the areas covered by the laser printed image washed away leaving no residue on the supporting mesh.

### EXAMPLE 3

Preparation of a screen printing origination film having an emulsion coating.
A photosensitive emulsion was prepared by blending the following ingredients on a high shear mixer

| Premix A: | |
|---|---|
| 12% aqueous dispersion GOHSENOL GH20 polyvinylalcohol | 100 g |
| Polyvinyl acetate homopolymer | 36g |
| UNISPERSE Blue | 1g |

| Premix B: | |
|---|---|
| Diazo FWD (Diazodiphenylamine-formaldehyde condensate supplied by Materiali Sensibili Srl, Milan, Italy) | 0.5g |
| Water | 6.0g |
| | |

Premix B was then stirred into Premix A. The photosensitive emulsion was allowed to deaerate for 6 hours. The emulsion was then coated to a thickness of thirty microns on the reverse of the toner receptive film prepared in example 2.
The film was then processed through a 600 dpi laser printer. The imaged film was then applied, emulsion side, to a 90 threads/cm polyester screen print mesh and adhered by water spray. The emulsion was dried, using a warm fan, and the screen then exposed to a 5kW metal halide lamp at 1.2 metres for three minutes. The imaged laser printed film was then removed from the photostencil. The photostencil was then washed with a cold water spray to develop the image. The emulsion washed away cleanly to give a screen printable stencil with no residue remaining in the open areas.
GOHSENOL is a registered trade mark of Nippon Gohsei.
FLUORAD is a registered trade mark of 3M.
MELINEX is a registered trade mark of ICI.
AUTOTYPE and CAPILLEX are registered trade marks of Autotype International Limited.
UNISPERSE is a registered trade mark of Ciba-Geigy Limited.

## Claims

1. An origination film for use in screen printing, the film comprising a translucent base film having a toner-receptive surface for receiving toner in an electrophotographic process.

2. An origination film according to claim 1, comprising a base film and an additional layer extending over the base film, the toner-receptive surface being a surface of the additional layer.

3. An origination film according to claim 2, in which the additional layer comprises a binder containing an inert filler.

4. An origination film according to claim 3, in which the ratio of binder to filler is in the range from 1:1 to 5:1 by weight.

5. An origination film according to claim 3 or 4, in which the binder in the additional layer is polyvinyl alcohol.

6. An origination film according to claim 3 or 4, in which the binder in the additional layer is a polyamide or a polyester.

7. An origination film according to any of claims 3 to 6, in which the filler in the additional layer comprises silica and/or china clay.

8. An origination film according to any of claims 3 to 6, in which the filler in the additional layer comprises a synthetic resin filler.

9. An origination film according to claim 8, in which the synthetic resin is a cross-linked urea-formaldehyde resin.

10. An origination film according to any of claims 2 to 9, in which the additional layer is from 5 to 20µm in thickness.

11. An origination film according to any preceding claim, in which the toner-receptive surface has a surface roughness of from 3 to 15µm.

12. An origination film according to claim 11, in which the toner-receptive surface has a surface roughness of from 5 to 12µm.

13. An origination film according to any preceding claim, in which the base film is from 50 to 100µm in thickness.

14. An origination film according to claim 13, in which the base film is from 70 to 80µm in thickness.

15. An origination film according to any preceding claim, in which the translucency of the base film is through inclusion therein of a filler.

16. An origination film according to claim 15, in which the filler comprises silica and/or china clay.

17. An origination film according to any preceding claim, in which the base film is of polyester.

18. An origination film according to any preceding claim, in which the base film has a transmission density to UV light of from 0.1 to 0.4.

19. An origination film according to any preceding claim, in which the side of the base film opposite to the toner-receptive surface is coated with a photosensitive emulsion layer which can be exposed imagewise to actinic light to form a screen printing stencil.

20. An origination film according to claim 19, in which the emulsion layer is from 10 to 50µm in thickness.

21. An origination film according to claim 20, in which the emulsion layer is from 20 to 40 µm in thickness.

22. Use in the preparation of a screen printing stencil of an origination film according to any preceding claim.
